# EUROPEAN PATENT APPLICATION

(11) **EP 4 513 547 A1**
(43) Date of publication of application: **26.02.2025**
(21) Application number: 23791703.4
(22) Date of filing: 07.04.2023
(51) Int. Cl.: H01L 23/13, H01L 23/12, H01L 23/36, H05K 1/02

(54) **CERAMIC CIRCUIT SUBSTRATE, SEMICONDUCTOR DEVICE, METHOD FOR MANUFACTURING CERAMIC CIRCUIT SUBSTRATE, AND METHOD FOR MANUFACTURING SEMICONDUCTOR DEVICE**

(30) Priority: 18.04.2022 JP 2022067982
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: UENO, Toshihide, Yokohama-shi, Kanagawa 235-0032 (JP)
(74) Representative: Hoffmann Eitle
(86) International application number: PCT/JP2023/014392
(87) International publication number: WO 2023/204054

(57) **Abstract**

A ceramic circuit substrate according to an embodiment includes a ceramic substrate, a metal circuit, and a metal member. The metal circuit is located at one surface of the ceramic substrate. The thickness of the metal circuit is not less than 1 mm. The metal member is located at another surface of the ceramic substrate. The thickness of the metal member is not less than 1 mm. A ratio *Vf*/*Vb* of a total volume Vf of the metal circuit to a total volume Vb of the metal member is not less than 0.80 and not more than 1.20.

## Description

### [Technical Field]

Embodiments relate generally to a ceramic circuit substrate, a semiconductor device, a method for manufacturing a ceramic circuit substrate, and a method for manufacturing a semiconductor device.

### [Background Art]

A ceramic circuit substrate is used in a semiconductor device in which a semiconductor element such as a power element or the like is mounted. A ceramic substrate and a metal circuit are bonded to each other via a bonding layer using a brazing material, etc. The bonding strength and heat cycle characteristics are improved thereby. As reliability is increased, ceramic circuit substrates are being used in inverters of automobiles (including electric vehicles), electric railway vehicles, solar power generation equipment, industrial machinery, etc. In a semiconductor device such as a power module or the like, a semiconductor element is mounted to a circuit. Also, wire bonding and/or the bonding of a metal terminal may be performed to electrically connect the semiconductor element. The semiconductor element, the wire bonding, the metal terminal, etc., are bonded to the circuit in the manufacture of the semiconductor device.

Ceramic substrates are becoming thinner with advances in downsizing, weight reduction, and higher-density mounting of power modules. Accordingly, there is a tendency for the warp of the ceramic circuit substrate to increase. As one method of reducing the warp of the ceramic circuit substrate, a method of regulating the area ratio and thickness ratio of a metal circuit board and a metal plate bonded to the surface opposite to the metal circuit board is discussed (Patent Literature 1). According to Patent Literature 1, the warp amount of the ceramic circuit substrate can be controlled by regulating these ratios.

Furthermore, with advances in higher output of semiconductor elements, there are cases where large currents or high voltages are applied to the semiconductor elements. It is therefore desirable to make the metal circuit board thick to carry a large current and increase the cooling effect of the circuit substrate. As a ceramic circuit substrate having a thicker metal circuit board, a method of bonding a thick circuit to a thin ceramic substrate is discussed (Patent Literature 2). According to Patent Literature 2, warp can be prevented by providing a copper circuit having a thickness of not less than 0.7 mm on the ceramic substrate, and by making the volumes of the copper circuit boards at the front and back equal or substantially equal.

### [Citation List]

### [Patent Literature]

Patent Literature 1: Japanese Patent No. 4557398
Patent Literature 2: Japanese Patent No. 6430382

### [Summary of Invention]

### [Problem to be Solved by the Invention]

On the other hand, problems due to thicker circuits have become apparent. For example, a metal plate bonded to the upper surface of a ceramic substrate is subdivided into multiple parts and patterned into a circuit configuration. In contrast, one undivided metal member is bonded to the lower surface of the ceramic substrate. When the thickness of the metal circuit at the upper surface and the thickness of the metal member at the lower surface are equal, the difference between the volume of the metal circuit and the volume of the metal plate is large. The difference between the thermal expansion amount of the metal circuit and the thermal expansion amount of the metal member increases as the difference between the volume of the metal circuit and the volume of the metal member increases. As a result, the warp of the ceramic circuit substrate increases.

Embodiments are directed to solve such problems, and are directed to provide a ceramic circuit substrate that can reduce warp even when a thick metal circuit is included.

### [Means for Solving the Problem]

A ceramic circuit substrate according to an embodiment includes a ceramic substrate, a metal circuit, and a metal member. The metal circuit is located at one surface of the ceramic substrate. The thickness of the metal circuit is not less than 1 mm. The metal member is located at another surface of the ceramic substrate. The thickness of the metal member is not less than 1 mm. A ratio *Vf*/*Vb* of a total volume Vf of the metal circuit to a total volume Vb of the metal member is not less than 0.80 and not more than 1.20.

### [Brief Description of Drawings]

[FIG. 1]

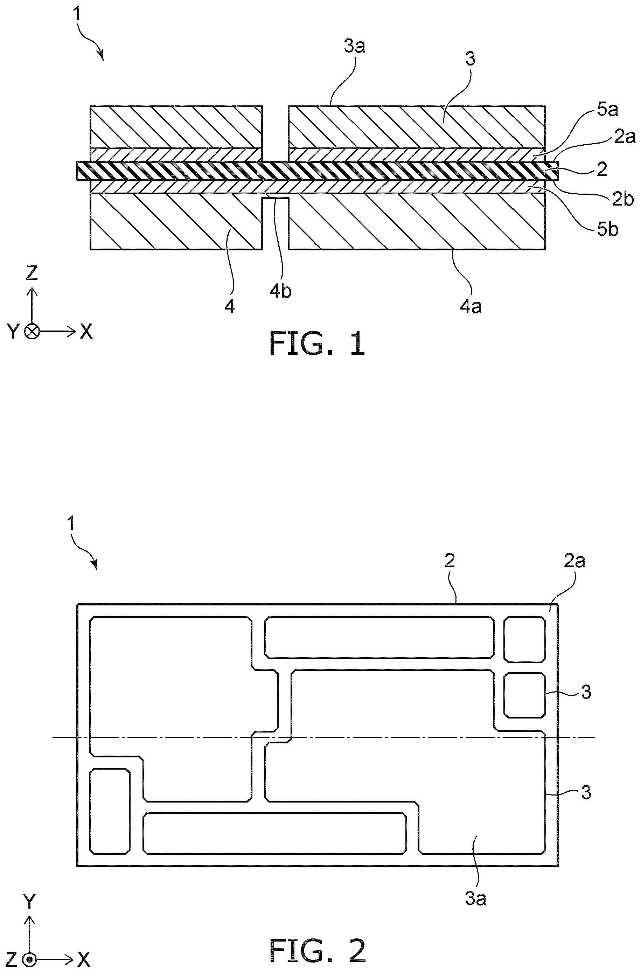

   FIG. 1 is a cross-sectional view showing an example of a ceramic circuit substrate according to an embodiment.
[FIG. 2]
   FIG. 2 is a top view showing an example of the ceramic circuit substrate according to the embodiment.
[FIG. 3]

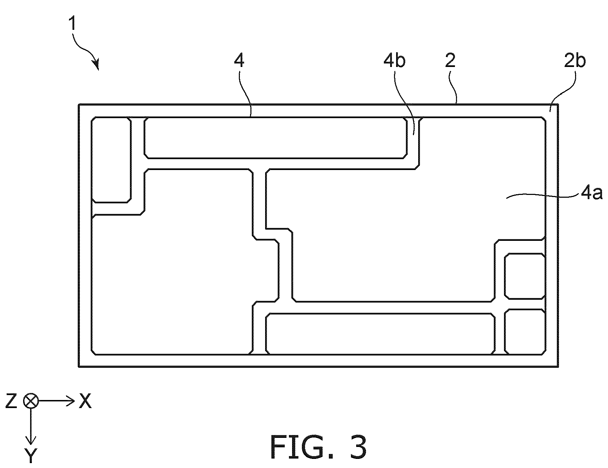

   FIG. 3 is a bottom view showing an example of the ceramic circuit substrate according to the embodiment.
[FIG. 4]

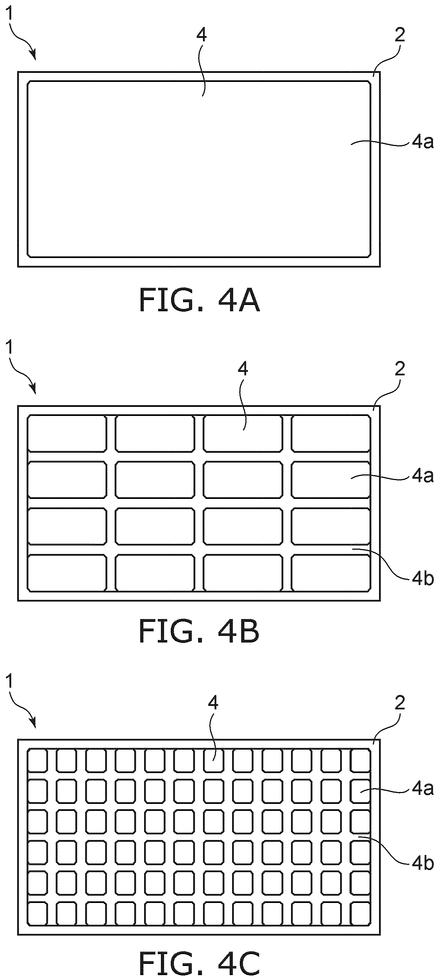

   FIG. 4 is bottom views showing other examples of the ceramic circuit substrate according to the embodiment.
[FIG. 5]

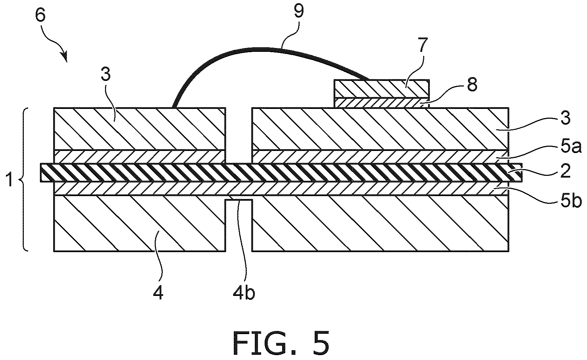

   FIG. 5 is a cross-sectional view showing an example of a semiconductor device according to an embodiment.
[FIG. 6]

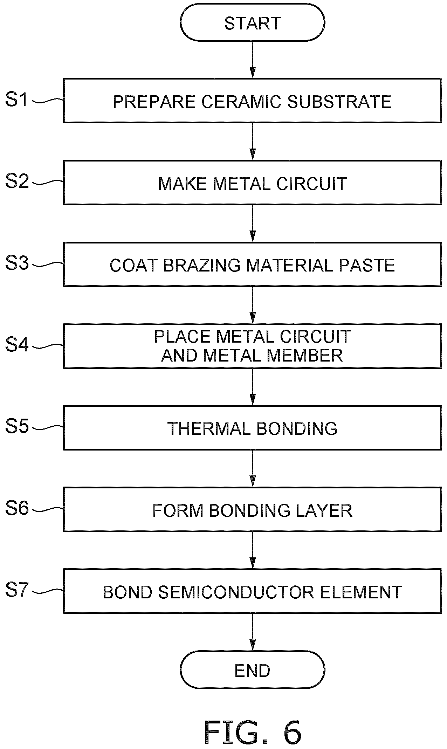

   FIG. 6 is a flowchart showing an example of a manufacturing method according to the embodiment.

### [Description of Embodiments]

A ceramic circuit substrate according to an embodiment includes a ceramic substrate, a metal circuit, and a metal member. The metal circuit is located at one surface of the ceramic substrate. The thickness of the metal circuit is not less than 1 mm. The metal member is located at another surface of the ceramic substrate. The thickness of the metal member is not less than 1 mm. A ratio *Vf*/*Vb* of a total volume Vf of the metal circuit to a total volume Vb of the metal member is not less than 0.80 and not more than 1.20.

FIG. 1 is a cross-sectional view showing an example of a ceramic circuit substrate according to an embodiment. In FIG. 1, 1 is a ceramic circuit substrate. 2 is a ceramic substrate. 3 is a metal circuit. 3a is the upper surface of the metal circuit 3. 4 is a metal member. 4a is the lower surface of the metal member. 4b is a groove formed in the metal member. 5a and 5b are a first bonding layer and a second bonding layer including brazing materials.

Herein, an XYZ orthogonal coordinate system is used to describe the embodiments. A direction connecting one surface (an upper surface 2a) and another surface (a lower surface 2b) of the ceramic substrate 2 is taken as a "Z-direction". Two mutually-orthogonal directions perpendicular to the Z-direction are taken as an X-direction and a Y-direction. Also, a direction parallel to the Z-direction from the metal member 4 toward the metal circuit 3 is called "up", and the opposite direction is called "down". These directions are based on the relative positional relationship between the metal circuit 3 and the metal member 4, and are independent of the direction of gravity.

The ceramic substrate 2 includes two flat surfaces. Herein, one surface of the ceramic substrate 2 is taken as the upper surface 2a (the front surface, the one surface). Another surface of the ceramic substrate 2 is taken as the lower surface 2b (the back surface, the other surface). The metal circuit 3 is bonded to the upper surface 2a via the first bonding layer 5a. The metal member 4 is bonded to the lower surface 2b via the second bonding layer 5b. In the example of FIG. 1, multiple metal circuits 3 are bonded to the upper surface 2a respectively via multiple first bonding layers 5a. The embodiment is not limited to the illustrated example. One metal circuit 3 or three or more metal circuits 3 may be bonded to the upper surface 2a. Also, in the example of FIG. 1, the metal member 4 is bonded to the lower surface 2b. The metal member 4 functions not as a circuit, but as a heat dissipation plate.

It is favorable for the ceramic substrate 2 to be one of an aluminum oxide substrate, an aluminum nitride substrate, or a silicon nitride substrate. An Alusil substrate also is an example of one type of aluminum oxide substrate. Alusil is a sintered body made of 20 to 80 wt% aluminum oxide, with the remainder being zirconium oxide.

The three-point bending strength of an aluminum nitride substrate or an aluminum oxide substrate is about 300 to 450 MPa. The three-point bending strength of an Alusil substrate is about 550 MPa. By using a silicon nitride substrate, the three-point bending strength of the ceramic substrate 2 can be increased to not less than 600 MPa, or even not less than 700 MPa. Also, the thermal conductivity can be increased to not less than 50 W/(m·K), or even not less than 80 W/(m·K). In particular, in recent years, there is also a silicon nitride substrate having both high strength and high thermal conductivity. The silicon nitride substrate can be made thinner due to the high strength. The heat dissipation can be improved thereby. It is therefore favorable for the thickness of the silicon nitride substrate to be not more than 0.635 mm, and more favorably not more than 0.3 mm. Although not particularly limited, it is favorable for the lower limit of the thickness to be not less than 0.1 mm. This is to ensure the electrical insulation of the silicon nitride substrate. "Thickness" corresponds to the dimension in the Z-direction of the ceramic substrate 2.

These ceramic substrates may be single plates, or may have a three-dimensional structure such as a multilayer structure, etc. The thickness of the ceramic substrate is not particularly limited. The heat dissipation is improved by making the ceramic circuit substrate thinner and making the metal circuit thicker.

FIG. 2 is a top view showing an example of the ceramic circuit substrate according to the embodiment. The broken line of FIG. 2 illustrates the cross-sectional location of FIG. 1.

As shown in FIG. 2, the multiple metal circuits 3 are bonded to the upper surface 2a. In the example shown in FIG. 2, seven metal circuits 3 are bonded. When forming the metal circuit, there are a first method of bonding , to the ceramic substrate 2, the metal circuit 3 in which a circuit is pre-formed, and a second method of forming a circuit by etching a metal plate part.

In the first method, cutting or molding other than chemical etching is used to pattern a metal plate into the metal circuits 3 before bonding. For example, molding is pressing in which a metal plate is stamped by a die assembly. Cutting is patterning that forms a groove part with a lathe, etc. Wire cutting is patterning that cuts a metal plate by melting while providing a current to an electrode. When the first method is performed, the side surfaces of the metal circuits 3 are substantially parallel to the Z-direction. The volumes of the metal circuits 3 can be calculated by multiplying the areas when the metal circuits 3 are viewed along the Z-direction by the thickness of the metal circuits 3. The total volume Vf can be calculated by adding the volumes of the metal circuits 3.

When the second method is performed, dissolution proceeds along the crystal grain boundaries included in the metal plate in the etching of the metal plate. Therefore, dissolution proceeds not only in the thickness direction of the metal plate, but also in the planar direction perpendicular to the thickness direction. In other words, side etching occurs. The etching time of the metal plate lengthens as the metal plate thickness increases. As the etching time lengthens, the etching proceeds more in the planar direction of the metal plate; and the side etching amount also increases. The total volume Vf of the metal circuit 3 is calculated by considering the side etching amount. Specifically, the shape of the metal circuit 3 after the etching can approximate a frustum. In the example shown in FIG. 2, the shapes of the metal circuits 3 can approximate quadrilateral truncated pyramids. The volume of each metal circuit 3 is calculated from the area of the upper base, the area of the lower base, and the thickness of the metal circuit 3. The sum of these volumes is the total volume Vf.

Other than these methods, there is a method in which individual metal circuits are formed as a continuous body by bridges, and then bonded; and the bridge parts are removed after bonding. Similarly, in such a case as well, the total volume Vf is calculated from the volumes of the metal circuits 3 after bonding.

As shown in FIG. 2, multiple independent metal circuits 3 are formed on the upper surface 2a of the ceramic substrate 2. The ceramic substrate 2 insulates between the metal circuits 3.

A semiconductor element or the like is bonded to the metal circuit 3. It is favorable for the thickness of the metal circuit 3 to be not less than 1.0 mm to reduce the thermal resistance and reduce the inductance. It is more favorable for the thickness of the metal circuit 3 to be not less than 2.0 mm, and most favorably not less than 3.0 mm.

FIG. 3 is a bottom view showing an example of the ceramic circuit substrate according to the embodiment.

As shown in FIG. 3, the metal member 4 is bonded to the lower surface 2b of the ceramic substrate 2. In FIGS. 3, 4a is the lower surface of the metal member. 4b is a groove formed in the metal member 4. The metal member 4 may be used as a heat dissipation plate, or may be bonded to another component. As shown in FIG. 3, the metal member 4 in which a circuit configuration is formed at a surface (the lower surface 4a) of the metal member 4 may be located at the lower surface 2b. In the illustrated example, the groove 4b is formed so that the metal member 4 has the same shape as the multiple metal circuits 3 shown in FIG. 2. In other words, at least a portion of the groove 4b is arranged with the gap between the metal circuits 3 in the Z-direction. Also, the shape and size of the outer edge of the metal member 4 when viewed along the Z-direction are substantially the same as the shape and size of the smallest quadrilateral surrounding the multiple metal circuits 3 when viewed along the Z-direction. The depth of the groove 4b (the dimension in the Z-direction) is, for example, not less than 0.5 times the thickness of the metal member 4.

To reduce the thermal resistance, it is favorable for the thickness of the metal member to be not less than 1.0 mm. The thickness of the metal member is more favorably not less than 2.0 mm, and most favorably not less than 3.0 mm.

Even when the thickness of the metal circuit 3 and the thickness of the metal member 4 are less than the values described above, the effects of the invention are obtained by controlling the total volume Vf of the metal circuit 3 and the total volume Vb of the metal member 4. The invention is particularly effective when the metal circuit 3 and the metal member 4 are thick. To reduce the thermal resistance, it is favorable for the thicknesses of the metal circuit 3 and the metal member 4 to be not less than 1.0 mm. On the other hand, when the metal circuit 3 and the metal member 4 are thick, the difference between the total volume Vf and the total volume Vb easily increases. As a result, the warp of the ceramic circuit substrate 1 also increases easily. According to the embodiment of the invention, by controlling the total volume Vf of the metal circuit 3 and the total volume Vb of the metal member 4, the warp of the ceramic circuit substrate 1 can be reduced even when the metal circuit 3 and the metal member 4 are thick.

Although not particularly limited, it is favorable for the upper limits of the thicknesses of the metal circuit 3 and the metal member 4 to be not more than 20 mm. When the thickness is greater than 20 mm, there is a possibility that stress may concentrate at the bonding interface, and cracks may occur in the ceramic substrate 2. To suppress the occurrence of cracks, it may be difficult to make the ceramic substrate 2 thinner.

The ceramic circuit substrate 1 according to the embodiment includes the ceramic substrate 2, the metal circuit 3, and the metal member 4. The metal circuit 3 and the metal member 4 are bonded respectively to the upper surface 2a and the lower surface 2b of the ceramic substrate 2. The thicknesses of the metal circuit 3 and the metal member 4 are not less than 1.0 mm. It is favorable for the ratio *Vf*/*Vb* of the total volume Vf of the metal circuit 3 to the total volume Vb of the metal member 4 to be not less than 0.80 and not more than 1.20.

A semiconductor element is mounted to the metal circuit 3 of the ceramic circuit substrate 1. The semiconductor element generates heat when a current flows in the semiconductor element. The heat that is generated by the semiconductor element is conducted to the ceramic circuit substrate 1, thereby increasing the temperature of the ceramic circuit substrate 1.

When the ratio *Vf*/*Vb* is within the range of not less than 0.80 and not more than 1.20, the difference between the thermal expansion of the metal circuit 3 and the thermal expansion of the metal member 4 is small. When the temperature of the ceramic circuit substrate 1 increases, the stress generated by the difference between the thermal expansion of the metal circuit 3 and the thermal expansion of the metal member 4 is relaxed. By relaxing the stress of the ceramic circuit substrate 1, the warp of the ceramic circuit substrate 1 is reduced. Also, by relaxing the stress of the ceramic circuit substrate 1, the bonding strength, substrate bending strength, and heat cycle resistance are improved.

The thermal stress due to the thermal expansion difference tends to increase as the metal circuit 3 and the metal member 4 become thicker. Therefore, the ratio *Vf*/*Vb* is within the range of not less than 0.80 and not more than 1.20, and favorably near 1. The ratio *Vf*/*Vb* is more favorably not less than 0.90 and not more than 1.10, and more favorably not less than 0.95 and not more than 1.05.

In the ceramic circuit substrate 1 according to the embodiment, the thicknesses of the metal circuit 3 and the metal member 4 and the ratio *Vf*/*Vb* are controlled. When the metal circuit 3 and the metal member 4 are bonded on the ceramic substrate 2, the ceramic circuit substrate 1 having excellent reliability can be obtained by controlling the thickness and the ratio *Vf*/*Vb* to be respectively within the ranges mentioned above.

FIGS. 4A to 4C are bottom views showing other examples of the ceramic circuit substrate according to the embodiment.

As shown in FIG. 4A, the metal member 4 that is located at the lower surface 2b may not have a circuit configuration. In other words, in the example shown in FIG. 4A, the single plate-shaped metal member 4 is located at the lower surface 2b of the ceramic substrate 2. When manufacturing the ceramic circuit substrate 1 shown in FIG. 4A, the ratio *Vf*/*Vb* is controlled to be not less than 0.8 and not more than 1.2 by pre-calculating the total volume Vf of the metal circuit 3, and by adjusting the thickness of the metal member 4.

Other than adjusting the thickness of the metal member 4, the total volume Vb of the metal member 4 may be adjusted by forming a groove (a recess) in the metal member 4. In FIGS. 4B and 4C, 4b shows a groove formed in the metal member 4. In the examples shown in FIGS. 4B and 4C, a lattice-shaped groove 4b is formed. The groove 4b can be formed by cutting, stamping, or etching. The total volume Vb of the metal member 4 can be reduced by forming the groove 4b in the metal member 4. For example, even when the thickness of the metal circuit 3 and the thickness of the metal member 4 are equal, the ratio *Vf*/*Vb* can be controlled to be within the range of not less than 0.8 and not more than 1.2 by forming the groove 4b in the metal member 4. Also, the heat dissipation of the metal member 4 can be improved by not dividing the metal member 4 into multiple members so that the parts of the metal member 4 remain connected to each other at the bottom portion of the groove 4b.

Other than adjusting the thickness or forming a groove, the total volume Vb also can be adjusted by adjusting the area of the metal member 4 in the X-Y plane (a first plane). By adjusting the area of the metal member 4, the ratio *Vf*/*Vb* may be controlled within the range of not less than 0.8 and not more than 1.2.

The warp of the ceramic circuit substrate 1 easily increases when the difference between the sum of the areas of the multiple metal circuits 3 in the X-Y plane and the sum of the areas of the metal member 4 in the X-Y plane becomes excessively large. It is therefore favorable for a ratio *Af*/*Ab* of a sum Af of the areas of the multiple metal circuits 3 in the X-Y plane to an area Ab of the metal member 4 in the X-Y plane to be not less than 0.80 and not more than 1.20. More favorably, the ratio *Af*/*Ab* is not less than 0.90 and not more than 1.10. The warp of the ceramic circuit substrate can be further reduced by controlling the ratio *Af*/*Ab* in addition to the ratio *Vf*/*Vb.*

Examples of metals included in the metal circuit 3 and the metal member 4 include copper, copper alloys, aluminum, aluminum alloys, etc. Copper and copper alloys have high electrical conductivity and are excellent as electrical circuit materials. Also, copper and copper alloys have high thermal conductivity and are excellent for heat dissipation of the semiconductor element mounted on the metal circuit.

It is favorable for the metal circuit 3 and the metal member 4 to be bonded to the ceramic substrate 2 respectively via the first and second bonding layers 5a and 5b. It is favorable for the first and second bonding layers 5a and 5b to include at least two selected from the group consisting of silver, copper, titanium, zirconium, hafnium, niobium, tin, indium, zinc, aluminum, silicon, carbon, and magnesium.

When the metal circuit 3 and the metal member 4 are made of copper or a copper alloy, it is favorable for a bonding layer including Cu (copper) and Ti (titanium) to be located between the ceramic substrate and each of the metal circuits. The bonding layer that includes Cu and Ti is formed using an active metal brazing material. Ti is an active metal. Other than Ti, examples of active metals include Zr (zirconium), Hf (hafnium), and Nb (niobium). A mixture of Ti, Cu, and Ag (silver) is an example of the active metal brazing material. For example, the Ti content is 0.1 to 10 wt%, the Cu content is 10 to 60 wt%, and the remainder is Ag. As necessary, 1 to 15 wt% of at least one selected from the group consisting of In (indium), Sn (tin), Al (aluminum), Si (silicon), C (carbon), and Mg (magnesium) may be added. In active metal bonding using an active metal brazing material, an active metal brazing material paste is coated onto the surfaces of the ceramic substrate 2; and metal plates are placed on the active metal brazing material paste. The ceramic substrate and the metal plates are bonded by heating the stacked body thus obtained at 600 to 900 °C. According to the active metal bonding, the bonding strength between the ceramic substrate 2 and the metal circuit 3 and the bonding strength between the ceramic substrate 2 and the metal member 4 can be not less than 50 MPa.

When the metal circuit 3 and the metal member 4 are made of aluminum or an aluminum alloy, it is favorable for a bonding layer including Al (aluminum) and Si (silicon) to be located between the ceramic substrate and each of the metal circuits. The bonding layer that includes Al and Si is formed using an aluminum brazing material. For example, the Si content is 8 to 15 wt%, and the remainder is Al. As necessary, 1 to 15 wt% of at least one selected from the group consisting of In (indium), Sn (tin), Ti (titanium), Cu (copper), Ag (silver), C (carbon), and Mg (magnesium) may be added. In a brazing bonding method using an aluminum brazing material, an aluminum brazing material paste is coated onto the ceramic substrate surfaces; and metal plates are placed on the aluminum brazing material paste. The ceramic substrate and the metal plates are bonded by heating the stacked body thus obtained at 500 to 700 °C. According to the aluminum brazing bonding method, the bonding strength between the ceramic substrate 2 and the metal circuit 3 and the bonding strength between the ceramic substrate 2 and the metal member 4 can be not less than 50 MPa.

A metal thin film that includes one selected from the group consisting of Ni (nickel), Ag (silver), and Au (gold) as a major component may be located at the surface of the metal circuit 3 or the metal member 4. Examples of the metal thin film include a plating film, a sputtered film, etc. Corrosion resistance, solder wettability, etc., can be improved by including the metal thin film.

The ceramic circuit substrate 1 according to the embodiment is favorable for a semiconductor device. In the semiconductor device, a semiconductor element is mounted on the metal circuit via the bonding layer.

FIG. 5 is a cross-sectional view showing an example of a semiconductor device according to an embodiment.

In FIG. 5, 1 is a ceramic circuit substrate. 6 is a semiconductor device. 7 is a semiconductor element. 8 is a bonding layer. 9 is wire bonding. In the example shown in FIG. 5, the multiple metal circuits 3 are bonded to the upper surface 2a of the ceramic substrate 2. The semiconductor element 7 is bonded on one metal circuit 3 via the bonding layer 8. The wire bonding 9 electrically connects the metal circuit 3 to which the semiconductor element 7 is bonded and another metal circuit 3. The metal member 4 is bonded to the lower surface 2b. The groove 4b is formed in the metal member 4; and the ratio *Vf*/*Vb* is controlled to be not less than 0.80 and not more than 1.20.

The semiconductor device according to the embodiment is not limited to such a structure. For example, multiple semiconductor elements 7 may be located respectively on the multiple metal circuits 3. The multiple semiconductor elements 7 and the multiple wire bonding 9 may be located on one metal circuit 3. A semiconductor element and wire bonding also may be bonded to the metal member 4 as necessary. A metal terminal such as a leadframe, etc., may be bonded to the metal circuit 3 or the metal member 4.

The bonding layer 8 that bonds the semiconductor element 7 includes solder, a brazing material, etc. It is favorable for the solder to be lead-free solder. Solder refers to a material having a melting point of not more than 450 °C. Brazing material refers to a material having a melting point greater than 450 °C. Also, brazing materials having melting points of not less than 500 °C are called high-temperature brazing materials. Examples of high-temperature brazing materials include a brazing material including Ag as a major component.

In the ceramic circuit substrate 1 according to the embodiment, the ratio *Vf*/*Vb* of the total volume Vf of the metal circuit 3 to the total volume Vb of the metal member 4 is not less than 0.80 and not more than 1.20. Therefore, the stress that is generated in the ceramic circuit substrate 1 can be relaxed. Residual stress due to the bonding between the ceramic substrate 2 and each of the metal circuits is generated in the ceramic circuit substrate 1. Furthermore, normally, a semiconductor element is mounted on a metal circuit. A thermal expansion difference occurs between the ceramic substrate and the metal circuit; and stress is generated by the heat generated by the semiconductor element. Because the ratio *Vf*/*Vb* is not less than 0.80 and not more than 1.20, the stress generated in the metal circuit is reduced. When the stress on the metal circuit is small, the occurrence of cracks, etc., due to the stress difference between the ceramic substrate 2 and the metal circuits can be suppressed even when the thickness of the metal circuit is not less than 1 mm. From this aspect, according to the embodiment, the reliability of the ceramic circuit substrate can be increased.

Also, while semiconductor elements are becoming smaller, the heat generation amount from semiconductor elements is increasing. It is therefore important to improve the heat dissipation of the ceramic circuit substrate to which the semiconductor element is mounted. Multiple semiconductor elements may be mounted on a ceramic circuit substrate to increase the sophistication of the semiconductor device (the semiconductor module). When the temperature of any of the semiconductor elements exceeds the intrinsic temperature, the temperature coefficient that indicates the change of the electrical resistance with respect to the temperature changes from positive to negative. In other words, the electrical resistance also decreases as the temperature increases. Accordingly, a phenomenon occurs in which thermal runaway occurs in which concentrated power flows, and breakdown of the semiconductor device occurs. As a result, it is extremely effective to increase the reliability of the bond between the semiconductor element and the metal circuit. Also, the semiconductor device according to the embodiment can be used in a PCU, IGBT, or IPM module used in an inverter of an automobile (including an electric vehicle), an electric railway vehicle, industrial machinery, an air conditioner, etc. Among automobiles, electric vehicles are becoming increasingly popular. The safety of the automobile can be increased as the reliability of the semiconductor device increases. This is similar for electric railway vehicles, industrial devices, etc.

A method for manufacturing the ceramic circuit substrate 1 according to the embodiment will now be described. The method for manufacturing the ceramic circuit substrate 1 is not particularly limited as long as the ceramic circuit substrate 1 has the configuration described above. Here, an example of a method that obtains the ceramic circuit substrate 1 with a high yield is illustrated.

First, the ceramic substrate 2 and metal plates used as the metal circuit 3 and the metal member 4 are prepared. It is favorable for the ceramic substrate 2 to be one selected from an aluminum oxide substrate, an aluminum nitride substrate, and a silicon nitride substrate. In particular, considering the heat dissipation of the entire ceramic circuit substrate 1, it is favorable for the ceramic substrate 2 to be a silicon nitride substrate having a thermal conductivity of not less than 50 W/(m·K), and a three-point bending strength of not less than 600 MPa. It is favorable for the metal plate to be made of one selected from copper or a copper alloy.

The ceramic substrate 2 that has a through-hole is prepared when the metal circuit 3 located at the upper surface 2a and the metal member 4 located at the lower surface 2b of the ceramic substrate 2 are electrically connected by the through-hole. The through-hole may be pre-formed in the compact stage. Or, the through-hole may be formed in the ceramic substrate 2 (the ceramic sintered body). The through-hole is formed by laser patterning, cutting, etc. Examples of cutting include boring with a drill, etc.

When the bonded body is not etched, the metal circuits 3 that are molded into the circuit configuration are bonded to the upper surface 2a. When the metal circuits 3 are formed using etching, metal plates that are calculated based on the circuit dimensions are used. It is favorable for the thickness of the metal plate bonded to the lower surface 2b to be adjusted according to the total volume Vf calculated from the circuit dimensions.

It is favorable for a copper plate or a copper alloy plate to be bonded with the ceramic substrate 2 by active metal bonding. In active metal bonding, an active metal brazing material in which an active metal such as Ti or the like is mixed with Cu is used. Examples of the active metal brazing material include a mixture of Ti and Cu, a mixture of Ti, Ag, and Cu, etc. For example, in the active metal brazing material, the Ti content is 0.1 to 10 wt%, the Cu content is 10 to 60 wt%, and the remainder is Ag. As necessary, at least one selected from the group consisting of In, Sn, Al, Si, C, and Mg may be added within the range of 1 to 15 wt%.

It is favorable for the aluminum plate or the aluminum alloy plate to be bonded with the ceramic substrate 2 by aluminum brazing. In aluminum brazing, an aluminum brazing material is used. A mixture of Al and Si is an example of an aluminum brazing material. For example, the Si content is 8 to 15 wt%, and the remainder is Al. 1 to 15 wt% of at least one selected from the group consisting of In, Sn, Ti, Cu, Ag, C, and Mg may be added as necessary.

The brazing material metal is used as a paste. The paste is made by mixing a brazing material component and an organic substance. In the paste, it is favorable to uniformly mix the brazing material component. When the brazing material component is distributed nonuniformly, the brazing may not be stable, and may cause bonding defects.

Then, the brazing material paste is coated onto the upper surface 2a and the lower surface 2b of the ceramic substrate 2. Metal plates are placed respectively on the pastes. When a metal plate is pre-molded into the metal circuit 3, the molded metal circuit 3 is placed on the paste. Similarly, when the metal member 4 having a circuit configuration is used, and the metal member 4 is pre-molded, the molded metal member 4 is placed on the paste.

Continuing, the ceramic substrate 2 and the metal plates are bonded by heating the stacked body of the ceramic substrate 2 and the metal plates. When a copper plate or a copper alloy plate is used, the stacked body is heated at 700 to 900 °C. When an aluminum plate or an aluminum alloy plate is used, the stacked body is heated at 500 to 700 °C. The heating process is performed in a vacuum or a nonoxidizing atmosphere as necessary. When the heating process is performed in a vacuum, it is favorable for the pressure to be not more than 1×10⁻² Pa. Examples of the nonoxidizing atmosphere include a nitrogen atmosphere, an argon atmosphere, etc. By performing the heating process in a vacuum or a nonoxidizing atmosphere, oxidization of the bonding layer can be suppressed. The bonding strength is increased thereby.

When the metal circuits 3 are formed by patterning by etching, the metal plate is patterned into a circuit configuration by etching after bonding. After bonding, the groove 4b may be formed in the metal plate (the metal member 4) at the lower surface 2b by etching as shown in FIG. 3, FIG. 4B, or FIG. 4C.

The ceramic circuit substrate 1 according to the embodiment can be manufactured by the processes described above. Then, a process of bonding the semiconductor element 7, etc., to the ceramic circuit substrate 1 is performed. The bonding layer 8 is located at the location at which the semiconductor element 7 is bonded. It is favorable for the bonding layer 8 to include solder or a brazing material. The bonding layer 8 is placed; and the semiconductor element 7 is placed on the bonding layer 8. The wire bonding 9 is included as necessary. The multiple semiconductor elements 7 and the multiple wire bonding 9 may be included as necessary.

FIG. 6 is a flowchart showing an example of the manufacturing method according to the embodiment.

FIG. 6 illustrates a case where a metal plate is pre-molded into a circuit configuration. First, the ceramic substrate 2 is prepared (step S1). The metal circuit 3 is made separately from the ceramic substrate 2 by performing pressing, cutting, or wire cutting of the metal plate (step S2). A brazing material paste is coated onto two surfaces of the ceramic substrate 2 (step S3). The metal circuit 3 is placed on the upper surface 2a of the ceramic substrate 2; and the metal member 4 is placed on the lower surface 2b (step S4). Thermal bonding is performed to bond the metal circuit 3 and the metal member 4 to the ceramic substrate 2 (step S5). Thus, the ceramic circuit substrate 1 according to the embodiment is manufactured.

Then, the bonding layer 8 is formed on the metal circuit 3 of the ceramic circuit substrate 1 (step S6). The semiconductor element 7 is provided on the bonding layer 8; and the semiconductor element 7 is bonded to the metal circuit 3 (step S7). Thus, the semiconductor device 6 according to the embodiment is manufactured.

As described above, the metal circuit 3 is formed by etching, pressing, cutting, wire cutting, etc. Generally, etching is more favorable than pressing, cutting, or wire cutting. When performing pressing, it is necessary to prepare a die assembly corresponding to the shape of the metal circuit 3. The die assembly is expensive, and so the manufacturing cost of the ceramic circuit substrate 1 increases. The patterning speed of cutting and the patterning speed of wire cutting are slow; and cutting and wire cutting are unsuitable for mass production. On the other hand, side etching does not occur when forming the metal circuit 3 by pressing, cutting, or wire cutting. Therefore, the control of the total volume Vf of the metal circuit 3 is easy.

In the ceramic circuit substrate 1 according to the embodiment, it is especially favorable to use the metal circuit 3 formed by pressing, cutting, or wire cutting. The thermal resistance of the metal circuit 3 and the inductance of the metal circuit 3 can be reduced as the thickness of the metal circuit 3 is increased. On the other hand, it takes more time to pattern the metal circuit 3 from the metal plate by etching as the thickness of the metal circuit 3 increases. Side etching proceeds as the time necessary for etching increases. Therefore, the control of the total volume Vf of the metal circuit 3 is difficult. By forming the metal circuit 3 by pressing, cutting, or wire cutting, it is easier to control the ratio *Vf*/*Vb* to be not less than 0.80 and not more than 1.20.

In addition to the ratio *Vf*/*Vb* of the ceramic circuit substrate 1 being not less than 0.80 and not more than 1.20, it is more favorable to control the volumes of the metal plates bonded to the ceramic substrate 2. Specifically, it is favorable for a ratio *Vf0*/*Vb0* of a total volume Vf0 of the metal circuits 3 (or the metal plates) bonded to the upper surface 2a of the ceramic substrate 2 to a total volume Vb0 of the metal member 4 bonded to the lower surface 2b of the ceramic substrate 2 to be not less than 0.80 and not more than 1.20.

When the ratio *Vf0*/*Vb0* is less than 1, the thermal expansion of the metal member 4 located at the lower surface 2b is greater than the thermal expansion of the metal circuit 3 located at the upper surface 2a. In such a case, the ceramic substrate 2, the metal circuit 3, and the metal member 4 are bonded in a state in which the metal member 4 is more expanded than the metal circuit 3. In the subsequent cooling, the metal member 4 contracts more than the metal circuit 3. As a result, the ceramic circuit substrate 1 warps in a convex shape in the upper surface direction. When the ratio *Vf0*/*Vb0* is less than 0.80, the stress on the bonded body is increased by the difference between the thermal expansion of the metal member 4 and the thermal expansion of the metal circuit 3; and the bonding strength, substrate bending strength, and heat cycle resistance may degrade.

When the ratio *Vf0*/*Vb0* is greater than 1, the thermal expansion of the metal circuit 3 is greater than the thermal expansion of the metal member 4. In such a case, the ceramic circuit substrate 1 warps in a convex shape in the lower surface direction. When the ratio *Vf0*/*Vb0* is greater than 1.20, the stress on the bonded body due to the difference between the thermal expansion of the metal member 4 and the thermal expansion of the metal circuit 3 increases. By increasing the stress of the bonded body, the bonding strength, substrate bending strength, and heat cycle resistance may degrade.

When the ratio *Vf0*/*Vb0* is not less than 0.80 and not more than 1.20, the stress that is generated by bonding can be relaxed. As a result, the bonding strength, substrate bending strength, and heat cycle resistance of the ceramic circuit substrate 1 can be further improved.

To control the ratio *Vf0*/*Vb0,* it is effective to bond the metal circuit 3 formed by pressing, cutting, or wire cutting to the upper surface 2a. When the metal circuit 3 is formed by etching a metal plate after bonding the metal plate to the upper surface 2a, the total volume Vf0 of the metal plate when bonding is greater than the total volume Vf of the metal circuit 3 after the patterning by etching. Therefore, the total volume Vf0 easily becomes large compared to the total volume Vb0. By using the metal circuit 3 formed by pressing, cutting, or wire cutting, it is easier to control the ratio *Vf0*/*Vb0* to be not less than 0.80 and not more than 1.20.

### (Examples)

### (Examples 1 to 12 and comparative examples 1 to 7)

The ceramic substrates shown in Table 1 were prepared. The prepared ceramic substrates were silicon nitride substrates, aluminum nitride substrates, and aluminum oxide (alumina) substrates. The thermal conductivity of the silicon nitride substrate was 90 W/(m·K), and the three-point bending strength was 650 MP. The thermal conductivity of the aluminum nitride substrate was 170 W/(m·K), and the three-point bending strength was 300 MPa. The thermal conductivity of the aluminum oxide substrate was 20 W/(m·K), and the three-point bending strength was 350 MPa. The size of the ceramic substrate was 30 mm long×55 mm wide. The thicknesses of the silicon nitride substrate were 0.32 mm and 0.63 mm. The thicknesses of the aluminum nitride substrate and the alumina substrate were 0.63 mm. In Table 1, the silicon nitride substrates are indicated by "Si₃N₄"; the aluminum nitride substrates are indicated by "AIN"; and the aluminum oxide substrates are indicated by "Al₂O₃". A thickness T1 (mm) of each ceramic substrate was as shown in Table 1.

Then, the metal plates shown in Table 1 were prepared. The metal plates were pre-patterned to the prescribed sizes by pressing. The shape of each metal circuit 3 bonded to the upper surface 2a was as shown in FIG. 2. The metal members 4 having the shapes shown in FIG. 3, FIG. 4A, FIG. B, or FIG. 4C were bonded to the lower surfaces 2b. The metal plates were copper plates or aluminum plates. When the metal plate was pre-molded into a circuit configuration, the dimensions of each circuit configuration were measured before bonding to determine the total volume. When the metal plate was patterned by etching after bonding with the ceramic substrate, a single-plate metal plate was used.

For the metal plate materials of Table 1, the copper plates are indicated by "Cu"; and the aluminum plates are indicated by "Al". A thickness T2 (mm) of the metal circuit at the upper surface 2a and a thickness T3 (mm) of the metal member at the lower surface 2b were as shown in Table 1. Also, the patterning methods from the metal plate to the metal circuit are shown in Table 1. In the examples indicated by "pressing", the metal circuit 3 was formed by stamping the metal plate by pressing. In the examples indicated by "etching", the metal plate was patterned into the metal circuit 3 by etching. In the examples 1 to 7, the examples 9 to 12, the comparative examples 1 to 3, and the comparative examples 6 to 7, metal plates were prepared in which the groove 4b was formed by cutting.

**[Table 1]**

| | Substrate | T1(mm) | Metal plate | T2 (mm) | T3(mm) | Shape | Formation method |
|---|---|---|---|---|---|---|---|
| Example 1 | Si₃N₄ | 0.25 | Cu | 2.0 | 2.0 | FIG. 3 | Pressing |
| Example 2 | Si₃N₄ | 0.25 | Cu | 4.0 | 4.0 | FIG. 3 | Pressing |
| Example 3 | Si₃N₄ | 0.25 | Cu | 6.0 | 6.0 | FIG. 3 | Pressing |
| Example 4 | Si₃N₄ | 0.25 | Cu | 6.0 | 5.0 | FIG. 3 | Pressing |
| Example 5 | Si₃N₄ | 0.25 | Cu | 6.0 | 6.0 | FIG. 3 | Pressing |
| Example 6 | Si₃N₄ | 0.25 | Cu | 6.0 | 6.0 | FIG. 3 | Etching |
| Example 7 | Si₃N₄ | 0.63 | Cu | 8.0 | 8.0 | FIG. 3 | Pressing |
| Example 8 | Si₃N₄ | 0.25 | Cu | 6.0 | 5.0 | FIG. 4A | Pressing |
| Example 9 | Si₃N₄ | 0.25 | Cu | 6.0 | 6.0 | FIG. 4B | Pressing |
| Example 10 | Si₃N₄ | 0.25 | Cu | 6.0 | 6.0 | FIG. 4C | Pressing |
| Example 11 | AlN | 0.63 | Al | 4.0 | 4.0 | FIG. 3 | Pressing |
| Example 12 | Al₂O₃ | 0.63 | Al | 4.0 | 4.0 | FIG. 3 | Pressing |
| Comparative example 1 | Si₃N₄ | 0.25 | Cu | 6.0 | 6.0 | FIG. 3 | Pressing |
| Comparative example 2 | Si₃N₄ | 0.25 | Cu | 6.0 | 5.0 | FIG. 3 | Pressing |
| Comparative example 3 | Si₃N₄ | 0.25 | Cu | 6.0 | 6.0 | FIG. 3 | Etching |
| Comparative example 4 | Si₃N₄ | 0.25 | Cu | 6.0 | 6.5 | FIG. 4A | Pressing |
| Comparative example 5 | Si₃N₄ | 0.25 | Cu | 6.0 | 4.0 | FIG. 4A | Pressing |
| Comparative example 6 | AlN | 0.63 | Al | 4.0 | 4.0 | FIG. 3 | Pressing |
| Comparative example 7 | Al₂O₃ | 0.63 | Al | 4.0 | 3.0 | FIG. 3 | Pressing |

Then, a brazing material paste was made by mixing the brazing material raw materials and by mixing organic components. The brazing material paste was coated onto two surfaces of the ceramic substrate; and a metal plate or a metal circuit was placed on each of the two surfaces. At this time, the metal plate at the upper surface and the metal plate at the lower surface were arranged so that the metal plates squarely faced each other in the Z-direction. When placing the metal circuits, the multiple metal circuits were placed on the upper surface and the metal plate was placed on the lower surface so that the position, shape, and size of the smallest quadrilateral surrounding the multiple metal circuits 3 when viewed along the Z-direction substantially matched the position, shape, and size of the outer edge of the metal member 4 when viewed along the Z-direction.

When the material of the metal circuit was copper, an active metal brazing material was used. In the active metal brazing material, the Ti content was 2 wt%, the Sn content was 10 wt%, the Cu content was 30 wt%, and the remainder was Ag. When the material of the metal circuit was aluminum, an aluminum brazing material was used. In the aluminum brazing material, the Si content was 12 wt%, and the remainder was Al.

A thermal bonding process was performed on the obtained stacked bodies in a vacuum (not more than 1×10⁻² Pa). In the thermal bonding process, the bonding temperature was set to 820 °C when an active metal brazing material was used. The bonding temperature was set to 650 °C when an aluminum brazing material was used. The bonding time was set to 10 minutes. In the example 6 and the comparative example 3, the circuit configuration shown in FIG. 2 was formed by etching the metal plate at the upper surface after bonding. Also, in the examples 1 to 7, the examples 11 to 12, the comparative examples 1 to 3, and the comparative examples 6 to 7, the circuit configuration shown in FIG. 3 was formed by etching the metal plate at the lower surface after bonding.

For the metal circuits 3 located at the upper surface 2a, the total volume Vf was calculated from the dimensions of the metal circuits 3 after pressing in the examples 1 to 5, the examples 7 to 12, the comparative examples 1 to 2, and the comparative examples 4 to 7. In the example 6 and the comparative example 3, the area of the upper base (the upper surface 3a) of each metal circuit 3 and the distance between the metal circuits 3 were measured after the etching. The distance was measured along the upper surface 2a of the ceramic substrate 2. The areas of the lower bases of the metal circuits 3 were calculated from the distance. The shape of each metal circuit 3 approximated a quadrilateral truncated pyramid; and the total volume Vf was calculated from the area of the upper base, the area of the lower base, and the thickness of the metal circuit 3.

For the metal member 4 located at the lower surface 2b, the total volume Vb was calculated from the dimensions of the metal member 4 after the cutting in the examples 1 to 5, the example 7, the examples 11 to 12, the comparative examples 1 to 3, and the comparative examples 6 to 7. In the example 6 and the comparative example 3, the area of the upper base of each metal member 4 and the distance between the metal members 4 after the etching were measured. The shape of each metal member 4 approximated a quadrilateral truncated pyramid; and the total volume Vb was calculated from the area of the upper base (the lower surface 4a), the area of the lower base, and the thickness of the metal member 4. In the examples 9 to 10, the dimensions of the metal member 4 and the length and depth of the groove 4b were measured; and the total volume Vb was calculated from these values. The ratio *Vf*/*Vb* was calculated from the total volumes Vf and Vb.

The warp amount was measured using a three-dimensional profilometer for the ceramic circuit substrates according to the examples and the comparative examples. The warp amount is shown as positive when the ceramic circuit substrate had a convex shape in the direction of the metal circuit 3. The warp amount is shown as negative when the ceramic circuit substrate had a convex shape in the direction of the metal member 4. Also, the pull strength was measured as the bonding strength between the circuit and the ceramic substrate. The pull strength was measured by fixing the ceramic circuit substrate to a jig, and by peeling a portion of the metal circuit in the perpendicular direction at 50 mm/min.

Then, the reliability was evaluated for the ceramic circuit substrates according to the examples and the comparative examples. The bondability of the semiconductor element was evaluated as the reliability. To evaluate the bondability, the semiconductor element was bonded to the metal circuit of each ceramic circuit substrate using lead-free solder. Furthermore, wire bonding was performed to electrically connect the semiconductor element and a metal circuit to which the semiconductor element was not bonded. The semiconductor device was made thereby. A temperature cycle test (TCT) was performed on the semiconductor device; and the non-occurrence rate of delamination defects was determined. In the TCT, 50 cycles were performed, in which each cycle included holding for 30 minutes at -40 °C, holding for 10 minutes at room temperature, holding for 30 minutes at 150 °C, and holding for 10 minutes at room temperature. The delamination area due to cracks after 50 cycles was calculated by ultrasonic flaw detection (SAT: Scanning Acoustic Tomograph). The ultrasonic flaw detection identified portions where delamination due to cracks occurred and portions where no delamination occurred. The non-delamination area was calculated by subtracting the area of the portion where the delamination occurred from the area of the entire bonding portion. A non-delamination area ratio η was calculated by dividing the non-delamination area by the total area. The case where absolutely no cracks due to the TCT occurred was taken as *η =* 100%, and the case where cracks occurred in the entire bonding portion surface of the ceramic copper circuit substrate due to the TCT was taken as *η =* 0%. Table 2 shows the measurement results of the total volume Vf, total volume Vb, ratio *Vf*/*Vb,* warp amount, bonding strength, and non-delamination rate.

**[Table 2]**

| | Vf (cm³) | Vf (cm³) | Vf/Vb | Warp amount (mm) | Bonding strength (Mpa) | Non-delamination rate (%) |
|---|---|---|---|---|---|---|
| Example 1 | 2.33 | 2.40 | 0.97 | 0.5 | 37 | 81 |
| Example 2 | 4.67 | 4.70 | 0.99 | 0.5 | 43 | 85 |
| Example 3 | 7.00 | 7.10 | 0.99 | 0.5 | 49 | 87 |
| Example 4 | 7.00 | 5.90 | 1.19 | -0.7 | 35 | 80 |
| Example 5 | 7.00 | 8.60 | 0.81 | 0.7 | 38 | 79 |
| Example 6 | 6.72 | 8.26 | 0.81 | 0.7 | 40 | 82 |
| Example 7 | 9.34 | 9.30 | 1.00 | 0.4 | 54 | 92 |
| Example 8 | 7.00 | 7.02 | 1.00 | 0.6 | 40 | 82 |
| Example 9 | 7.00 | 7.50 | 0.93 | 0.5 | 41 | 85 |
| Example 10 | 7.00 | 8.00 | 0.88 | 0.5 | 45 | 85 |
| Example 11 | 4.67 | 4.70 | 0.99 | 0.4 | 33 | 87 |
| Example 12 | 4.67 | 4.70 | 0.99 | 0.4 | 31 | 86 |
| Comparative example 1 | 7.00 | 8.90 | 0.79 | 1.2 | 25 | 58 |
| Comparative example 2 | 7.00 | 5.80 | 1.21 | -1.1 | 21 | 49 |
| Comparative example 3 | 6.72 | 5.57 | 1.21 | -1.0 | 23 | 53 |
| Comparative example 4 | 7.00 | 9.13 | 0.77 | 1.3 | 20 | 52 |
| Comparative example 5 | 7.00 | 5.62 | 1.25 | -1.2 | 26 | 47 |
| Comparative example 6 | 4.67 | 6.02 | 0.78 | 0.8 | 20 | 54 |
| Comparative example 7 | 4.67 | 3.70 | 1.26 | -0.9 | 23 | 55 |

For the ceramic circuit substrates according to the examples 1 to 12, the ratio of the total volume Vf of the metal circuit 3 to the total volume Vb of the metal member 4 was within a favorable range. On the other hand, for the comparative examples 1 to 7, the ratio was outside the favorable range. Comparing the results of the examples 1 to 12 and the results of the comparative examples 1 to 7, the warp amounts of the ceramic circuit substrates according to the examples 1 to 12 were less than the warp amounts of the ceramic circuit substrates according to the comparative examples 1 to 7. It is considered that this is because the warp of the ceramic circuit substrate was suppressed by controlling the ratio *Vf*/*Vb* in the examples, and the stress due to the thermal expansion difference between the metal circuit 3 and the metal member 4 was large in the comparative examples.

Also, it can be seen that the bonding strengths of the ceramic circuit substrates according to the examples 1 to 12 were greater than the bonding strengths of the ceramic circuit substrates according to the comparative examples 1 to 7. It is considered that this is because the relaxation of the stress of the ceramic substrate 2 and the metal circuit 3 makes it difficult for cracks and the like to occur at the bonding interface between the metal circuit 3 and the semiconductor element 7. Furthermore, the non-delamination rate was not less than 79% for the examples 1 to 12, whereas the maximum non-delamination rate was 58% for the comparative examples 1 to 7. Therefore, it can be seen that controlling the ratio *Vf*/*Vb* is particularly effective for increasing the reliability against thermal cycles.

In the ceramic circuit substrates according to the examples 8 to 10, the metal members 4 respectively had the shapes of FIGS. 4A to 4C. Comparing the results of the examples 8 to 10, the difference between the ratio *Vf*/*Vb* and "1" was greater when the groove 4b was formed than when the groove 4b was not formed. On the other hand, the bonding strength and the non-delamination rate improved. It can be seen from this result that when the ratio *Vf*/*Vb* was about the same, the bonding strength and the non-delamination rate can be improved by providing the groove 4b. This was because stress concentration in the lower surface 2b and the metal member 4 can be relaxed by forming the groove 4b.

It can be seen from the results of Table 2 that according to the examples, ceramic circuit substrates having high reliability were obtained. Also, a large difference in the non-delamination area ratio η occurred between the examples and the comparative examples. It is considered that this is because in the examples, the bonding strength increased as a result of the warp amount being reduced by stress relaxation. In contrast, there was a tendency for the non-delamination area ratio η to degrade in the comparative examples. It is considered that this is due to the reduction of the bonding strength and the increased load applied to the bonding portion by the increased thermal stress inside the ceramic circuit substrate.

Embodiments of the invention include the following features.

### Note 1

A ceramic circuit substrate, comprising:
a ceramic substrate;
a metal circuit located at one surface of the ceramic substrate, the metal circuit having a thickness of not less than 1 mm; and
a metal member located at another surface of the ceramic substrate, the metal member having a thickness of not less than 1 mm,
a ratio *Vf*/*Vb* of a total volume Vf of the metal circuit to a total volume Vb of the metal member being not less than 0.80 and not more than 1.20.

### Note 2

The ceramic circuit substrate according to Note 1, wherein
a groove is formed in the metal member.

### Note 3

The ceramic circuit substrate according to any one of Notes 1 to 2, wherein the metal circuit is formed by pressing, cutting, or wire cutting.

### Note 4

The ceramic circuit substrate according to any one of Notes 1 to 3, wherein
a plurality of the metal circuits is located at the one surface of the ceramic substrate,
a ratio *Af*/*Ab* of a sum Af of areas of the plurality of metal circuits in a first plane to an area Ab of the metal member in the first plane is not less than 0.80 and not more than 1.20, and
the first plane is perpendicular to a first direction connecting the one surface and the other surface of the ceramic substrate.

### Note 5

The ceramic circuit substrate according to any one of Notes 1 to 4, wherein the thicknesses of the metal circuit and the metal member each are not less than 2 mm.

### Note 6

The ceramic circuit substrate according to any one of Notes 1 to 5, wherein the ceramic substrate is one selected from an aluminum oxide substrate, an aluminum nitride substrate, and a silicon nitride substrate.

### Note 7

The ceramic circuit substrate according to Note 6, wherein
a thickness of the ceramic substrate is not more than 0.7 mm.

### Note 8

The ceramic circuit substrate according to Note 7, wherein
the metal circuit and the metal member each are made of one selected from copper, a copper alloy, aluminum, and an aluminum alloy.

### Note 9

The ceramic circuit substrate according to Note 8, further comprising:
a first bonding layer bonding the ceramic substrate and the metal circuit; and
a second bonding layer bonding the ceramic substrate and the metal member,
the first bonding layer and the second bonding layer each including at least two selected from the group consisting of silver, copper, titanium, zirconium, hafnium, niobium, tin, indium, zinc, aluminum, silicon, carbon, and magnesium.

### Note 10

A semiconductor device, comprising:
the ceramic circuit substrate according to any one of Notes 1 to 9; and
a semiconductor element mounted to the metal circuit via a bonding layer.

### Note 11

A method for manufacturing a ceramic circuit substrate, the method comprising:
forming a metal circuit in a metal plate by performing pressing, cutting, or wire cutting;
bonding the metal circuit to one surface of a ceramic substrate; and
bonding a metal member to another surface of the ceramic substrate,
a ratio *Vf*/*Vb* of a total volume Vf of the metal circuit to a total volume Vb of the metal member being not less than 0.80 and not more than 1.20.

### Note 12

The method for manufacturing the ceramic circuit substrate according to Note 11, wherein
the thicknesses of the metal circuit and the metal member each are not less than 2 mm.

### Note 13

A method for manufacturing a semiconductor device, the method comprising:
mounting a semiconductor element, via a bonding layer, on the metal circuit of the ceramic circuit substrate manufactured by the manufacturing method according to Note 11 or Note 12.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 ceramic circuit substrate
2 ceramic substrate
2a upper surface
2b lower surface
3 metal circuit
3a metal circuit upper surface
4 metal member
4a metal member lower surface
4b groove
5a first bonding layer
5b second bonding layer
6 semiconductor device
7 semiconductor element
8 bonding layer
9 wire bonding

## Claims

1. A ceramic circuit substrate, comprising:
a ceramic substrate;
a metal circuit located at one surface of the ceramic substrate, the metal circuit having a thickness of not less than 1 mm; and
a metal member located at another surface of the ceramic substrate, the metal member having a thickness of not less than 1 mm,
a ratio *Vf*/*Vb* of a total volume Vf of the metal circuit to a total volume Vb of the metal member being not less than 0.80 and not more than 1.20.

2. The ceramic circuit substrate according to claim 1, wherein
a groove is formed in the metal member.

3. The ceramic circuit substrate according to claim 1 or claim 2, wherein
the metal circuit is formed by pressing, cutting, or wire cutting.

4. The ceramic circuit substrate according to claim 1 or claim 2, wherein
a plurality of the metal circuits is located at the one surface of the ceramic substrate,
a ratio *Af*/*Ab* of a sum Af of areas of the plurality of metal circuits in a first plane to an area Ab of the metal member in the first plane is not less than 0.80 and not more than 1.20, and
the first plane is perpendicular to a first direction connecting the one surface and the other surface of the ceramic substrate.

5. The ceramic circuit substrate according to claim 1 or claim 2, wherein
the thicknesses of the metal circuit and the metal member each are not less than 2 mm.

6. The ceramic circuit substrate according to claim 1 or claim 2, wherein
the ceramic substrate is one selected from an aluminum oxide substrate, an aluminum nitride substrate, and a silicon nitride substrate.

7. The ceramic circuit substrate according to claim 6, wherein
a thickness of the ceramic substrate is not more than 0.7 mm.

8. The ceramic circuit substrate according to claim 7, wherein
the metal circuit and the metal member each are made of one selected from copper, a copper alloy, aluminum, and an aluminum alloy.

9. The ceramic circuit substrate according to claim 8, further comprising:
a first bonding layer bonding the ceramic substrate and the metal circuit; and
a second bonding layer bonding the ceramic substrate and the metal member,
the first bonding layer and the second bonding layer each including at least two selected from the group consisting of silver, copper, titanium, zirconium, hafnium, niobium, tin, indium, zinc, aluminum, silicon, carbon, and magnesium.

10. A semiconductor device, comprising:
the ceramic circuit substrate according to claim 1 or claim 2; and
a semiconductor element mounted to the metal circuit via a bonding layer.

11. A method for manufacturing a ceramic circuit substrate, the method comprising:
forming a metal circuit in a metal plate by performing pressing, cutting, or wire cutting;
bonding the metal circuit to one surface of a ceramic substrate; and
bonding a metal member to another surface of the ceramic substrate,
a ratio *Vf*/*Vb* of a total volume Vf of the metal circuit to a total volume Vb of the metal member being not less than 0.80 and not more than 1.20.

12. The method for manufacturing the ceramic circuit substrate according to claim 11, wherein
the thicknesses of the metal circuit and the metal member each are not less than 2 mm.

13. A method for manufacturing a semiconductor device, the method comprising:
mounting a semiconductor element, via a bonding layer, on the metal circuit of the ceramic circuit substrate manufactured by the manufacturing method according to claim 11 or claim 12.
